# EUROPÄISCHE PATENTSCHRIFT

(11) **EP 1 522 148 B1**
(45) Veröffentlichungstag und Bekanntmachung des Hinweises auf die Patenterteilung: **03.01.2007**
(21) Anmeldenummer: 03787617.4
(22) Anmeldetag: 30.06.2003
(51) Int. Cl.: H03M 7/00

(54) **VERFAHREN ZUR CODIERUNG VON POSITIONEN VON DATENELEMENTEN IN EINER DATENSTRUKTUR**
METHOD FOR CODING POSITIONS OF DATA ELEMENTS IN A DATA STRUCTURE
PROCEDE DE CODAGE DE POSITIONS D'ELEMENTS DE DONNEES DANS UNE STRUCTURE DE DONNEES

(30) Priorität: 15.07.2002 DE 10231970
(43) Veröffentlichungstag der Anmeldung: 13.04.2005
(60) Teilanmeldung: 06016611.3
(73) Patentinhaber: SIEMENS AKTIENGESELLSCHAFT, 80333 München (DE)
(72) Erfinder: HEUER, Jörg, 82041 Oberhaching (DE); HUTTER, Andreas, 81673 München (DE)
(86) Internationale Anmeldenummer: PCT/DE2003/002168
(87) Internationale Veröffentlichungsnummer: WO 2004/017523

(56) Entgegenhaltungen:
- JOHN G. PROAKIS: "Digital communications, 2nd edition" 1989 , MCGRAW-HILL XP002259086 Seite IX
- "TEXT OF ISO/IEC FCD 15938-1 INFORMATION TECHNOLOGY - MULTIMEDIA CONTENT DESCRIPTION INTERFACE - PART 1 SYSTEMS" ISO/IEC JTC1/SC29/WG11, März 2001 (2001-03), Seiten 1-2,I-V,6-58, XP001001465

## Beschreibung

Verfahren zur Codierung von Positionen von Datenelementen in einer Datenstruktur

Die Erfindung betrifft ein Verfahren zur Codierung von Positionen von Datenelementen in einer Datenstruktur.

In einer Datenstruktur treten häufig Datenelemente auf, welche durch ihre Positionen zueinander unterschieden werden sollen. Bei Positionscodierverfahren wird dies dadurch ermöglicht, dass für alle Datenelemente in einer vorgegebenen Reihenfolge Positionscodes vergeben werden.

In [1] ist ein Positionscodierverfahren beschrieben, welches bei einem Verfahren zur binären Codierung von XML-Daten eingesetzt wird. Dieses Verfahren verwendet XML-Schema-Definitionen (beispielsweise im Rahmen eines standardisierten MPEG-7 Verfahrens), um die Codes für die einzelnen Datenelemente der XML-Beschreibung zu generieren. Dabei können einzelne Elemente bzw. Elementgruppen des gleichen Typs gemäß der XML-Schema-Definition mehrmals im Dokument auftreten. In diesem Fall wird ein Positionscode (PC) übertragen. Der Positionscode ist die binäre Repräsentation einer ganzen Zahl, welche die Position bezüglich der Nachbarelemente spezifiziert. Der Positionscode wird dem Element aufgrund der Position zu den Nachbarelementen in dem zu codierenden Dokument zugewiesen. Dies hat den Vorteil, dass der Positionscode eines Elementes erhalten bleibt, unabhängig von der Reihenfolge, in der benachbarte Elemente übertragen werden. Somit können bei der Übertragung Elemente verloren gehen, ohne dass dies die Positionscodes bzw. die Position der anschließend durch einen Decoder decodierten Elemente beeinflusst.

Ein Nachteil dieses bekannten Verfahrens ist, dass zum Zeitpunkt der Codierung das XML-Dokument bekannt sein muss, da mit der bisher existierenden Positionscodierung keine neuen Positionen eingefügt werden können, sondern lediglich neue Positionen angehängt werden können. Dies ist insbesondere dann ein Nachteil, wenn während der Erstellung eines XML-Dokumentes dieses bereits codiert bzw. übertragen werden soll, beispielsweise in Live-Übertragungen nach einem Übertragungs-Standard, z.B. MPEG-4 oder MPEG-7.

Zur Lösung dieses Problems können zwischen den verwendeten Positionscodes Lücken gelassen werden, die bei Bedarf aufgefüllt werden können. Insbesondere bei Live-Encodierung ist jedoch die vorab festzulegende, bedarfsgerechte Bereithaltung solcher Lücken schwer vorhersehbar. Außerdem ist die Gesamtanzahl möglicher Lücken in vielen Fällen durch die XML-Schema-Definition beschränkt. Stehen nun an der einzufügenden Position keine durch solche Lücken freigehaltenen Positionscodes mehr zur Verfügung, müssen alle bereits gesendeten, benachbarten Elemente mit neu generierten Positionscodes erneut übertragen werden. Insbesondere kommt dies häufig bei mehreren Datenelementen des gleichen Typs vor, z.B. bei mehrfach in einem Dokument auftretenden identischen Elementen bzw. Elementgruppen. Die Folge ist eine deutliche Verschlechterung der Codiereffizienz sowie ein deutlich erhöhter Verarbeitungsaufwand sowohl am Encoder als auch am Decoder.

Aufgabe der Erfindung ist es deshalb, ein Verfahren und eine Vorrichtung zur Codierung von Positionen von Datenelementen in einer Datenstruktur zu schaffen, bei denen auf einfache und effiziente Weise die Positionen von neu hinzukommenden Datenelementen codiert werden können.

Diese Aufgabe wird durch das Verfahren gemäß Anspruch 1 und die Vorrichtung gemäß Anspruch 11 bzw. 12 gelöst. Vorteilhafte Ausgestaltungen der Erfindung sind in den Unteransprüchen beschrieben.

Das erfindungsgemäße Verfahren hat den Vorteil, dass die Positionscodierung robust gegenüber Datenverlust ist, da Positionscodes beibehalten werden. Zugleich können bei der Verwendung des Verfahrens zur Codierung von XML-Dokumenten dynamische Dokumente, die während der Codierung erzeugt werden, effizient codiert werden. Dies wird dadurch ermöglicht, dass neue Positionen zwischen bestehenden Positionen codiert werden können, ohne dass Elemente und deren Positionscodes erneut übertragen werden müssen.

Eine Ausführungsform der Erfindung wird nachfolgend anhand der beigefügten Zeichnungen erläutert.

Es zeigen:
- Fig. 1: eine Darstellung eines Positionscodes eines Datenelements, wobei der Positionscode mithilfe des erfindungsgemäßen Verfahrens erzeugt wurde;
- Fig. 2: eine Datenstruktur, wobei den Datenelementen Positionscodes zugeordnet sind, die mithilfe des erfindungsgemäßen Verfahrens erzeugt wurden;
- Fig. 3: die Datenstruktur gemäß Fig.2, wobei zwei neue Datenelemente hinzugefügt worden sind.

In der nachfolgend betrachteten Ausführungsform der Erfindung werden den Datenelementen der Datenstruktur in aufsteigender Reihenfolge der Datenelement-Positionen Positionscodes zugewiesen, die ebenfalls in aufsteigender Reihenfolge angeordnete rationale Zahlen in einem vorgegebenen Wertebereich sind. Ist nun eine Position zwischen zwei existierenden Positionen zu adressieren, so ist dies immer möglich, da zwischen zwei gegebenen rationalen Zahlen R₁ und R₂ mit R₁≠R₂ immer eine infinitesimale Anzahl an rationalen Zahlen existiert. In realen Implementierungen ist diese Anzahl zwar nicht infinitesimal, kann aber immer ausreichend groß gewählt werden, beispielsweise >1024. Wenn der Positionscode des ersten Datenelements ungleich Null ist, können auch Datenelemente eingefügt werden, deren Positionscode kleiner als der Positionscode des ersten Datenelements ist.

Die Verwendung von rationalen Zahlen hat den weiteren Vorteil, dass eine möglichst kurze Binärdarstellung ermöglicht wird.

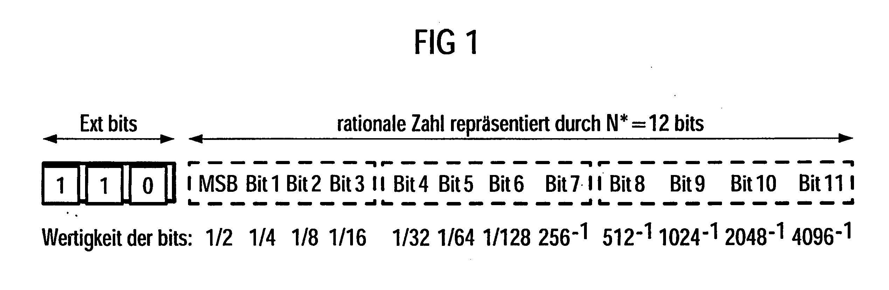

In Fig. 1 ist ein Positionscode eines Datenelements gezeigt. Dieser Positionscode ist die Binär-Darstellung einer rationalen Zahl zur Basis 2 im Wertebereich ]0,1[. Die Binär-Darstellung der rationalen Zahl umfasst N=15 Bits, wobei N*=12 Datenbits (MSB-Bit, Bit 1 bis Bit 11; N*<=N) vorhanden sind, welche in drei Quadrupeln angeordnet sind. Die Wertigkeiten der Datenbits sind jeweils unter den Bits genannt. Den Datenbits sind drei Extension-Bits vorangestellt, wobei die Anzahl der Extension-Bits die Anzahl der vorhandenen Datenbit-Quadrupel angibt. Die zwei vorderen Extension-Bits sind auf eins gesetzt, und das letzte Extension-Bit ist auf Null gesetzt. Durch das Setzen des letzten Extension Bits auf Null wird signalisiert, dass es sich bei den nachfolgenden Bits um Datenbits handelt. Mit der in Fig. 1 gewählten Darstellung wird somit eine rationale Zahl durch N Bits repräsentiert, von denen N* Bits Daten-Bits sind, wobei N*<=N und N*=4k ist ( k ist dabei eine ganze Zahl im Wertebereich [1,∝[).

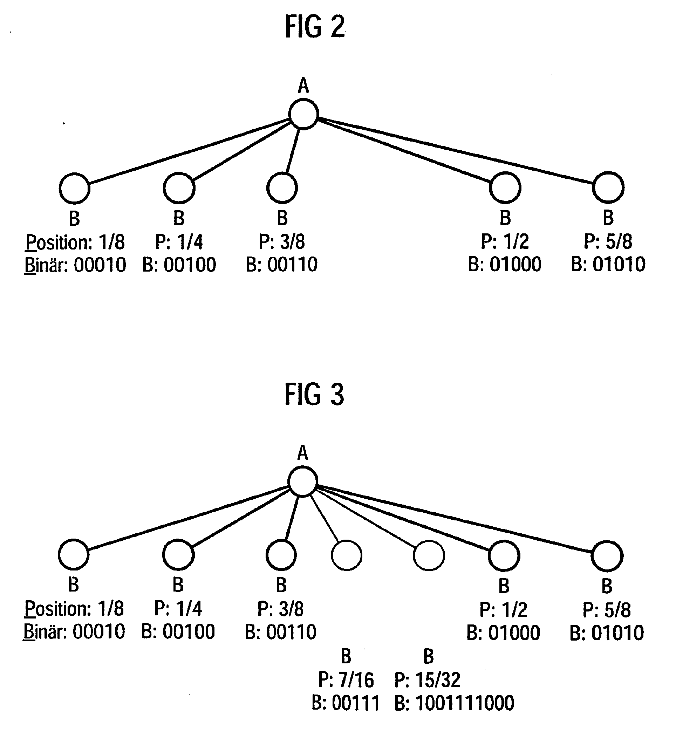

In Fig. 2 ist eine Datenstruktur in der Form eines Datenbaums gezeigt, wobei die Positionscodes der Datenelemente mit dem vorstehend beschriebenen Verfahren erzeugt wurden. Die Datenstruktur umfasst ein Datenelement A, das mit fünf Datenelementen B verknüpft ist. Den Datenelemente B sind Positionscodes P in aufsteigender Reihenfolge in der Form von rationalen Zahlen 1/8, 1/4, 3/8, 1/2 bzw. 5/8 zugeordnet. Ferner sind die Binärdarstellungen der Positionscodes gemäß der Darstellung der Fig. 1 angegeben.

In Fig. 3 ist eine Datenstruktur gemäß Fig. 2 gezeigt, wobei zwischen dem Datenelement mit dem Positionscode 3/8 und dem Datenelement mit dem Positionscode 1/2 noch zwei neue Datenelemente eingefügt worden sind. Diese neu hinzugefügten Datenelemente sind in Fig. 3 grau dargestellt. Durch die Verwendung von rationalen Zahlen für die Positionscodes können nun zwei Werte für die Positionscodes der neuen Datenelemente gefunden werden, die zwischen den Werten 3/8 und 1/2 liegen. In Fig. 3 wurden für diese Werte die Zahlen 7/16 und 15/32 gewählt. Es ist folglich möglich, neue Positionscodes für neue Datenelemente in der Datenstruktur zu generieren, ohne dass die bestehenden Positionscodes verändert werden müssen. Somit können zugewiesene Positionscodes bestehen bleiben und an beliebiger Position beliebig viele neue Datenelemente eingefügt werden.

### Literaturverzeichnis:

[1] ISO/IEC 15938-1 Multimedia Content Description Interface - Part 1: Systems, Geneva 2002

## Patentansprüche

1. Verfahren zur Codierung von Positionen von Datenelementen in einer Datenstruktur, bei dem
den Datenelementen Positionscodes in einer vorgegebenen Reihenfolge zugeordnet werden,
**dadurch gekennzeichnet, dass**
- die Positionscodes derart gewählt werden, dass für Positionen von weiteren Datenelementen zwischen den Positionen von zwei benachbarten Datenelementen weitere Positionscodes zur Codierung von Positionen von weiteren Datenelementen vergeben werden können, wobei die Codelänge von mindestens einem weiteren Positionscode größer als die längere der Codelängen der Positionscodes der zwei benachbarten Datenelemente ist,
- die Positionscodes rationale Zahlen repräsentieren.

2. Verfahren nach Anspruch 1, **dadurch gekennzeichnet, dass** der erste und/oder der letzte Positionscode der Datenelemente derart gewählt werden, dass vor dem ersten und/oder nach dem letzten Positionscode weitere Positionscodes eingefügt werden können.

3. Verfahren nach Anspruch 2, **dadurch gekennzeichnet, dass** der erste Positionscode ungleich null ist und/oder der letzte Positionscode ungleich eins ist.

4. Verfahren nach einem der vorhergehenden Ansprüche, **dadurch gekennzeichnet, dass** die Positionscodes Binärdaten sind.

5. Verfahren nach Anspruch 4, **dadurch gekennzeichnet, dass** die Positionscodes ein oder mehrere Datenbit-n-Tupel und ein oder mehrere Extension-Bits umfassen, wobei die Anzahl der Extension-Bits der Anzahl der Datenbit-n-Tupel entspricht.

6. Verfahren nach einem der vorhergehenden Ansprüche, **dadurch gekennzeichnet, dass** die Datenstruktur Teil eines Datenbaums ist.

7. Verfahren nach einem der vorhergehenden Ansprüche, **dadurch gekennzeichnet, dass** die Datenelemente Datencodes für die Datenelemente eines Dokuments sind.

8. Verfahren nach Anspruch 7, **dadurch gekennzeichnet, dass** das Dokument ein XML-Dokument ist.

9. Verfahren nach Anspruch 7 oder 8, **dadurch gekennzeichnet, dass** die Datencodes für das Dokument mit einem MPEG-Codierverfahren erzeugt werden.

10. Verfahren nach Anspruch 9, **dadurch gekennzeichnet, dass** das Codierverfahren ein standardisiertes MPEG-7 Codierverfahren ist.

11. Vorrichtung zur Codierung von Positionscodes von Datenelementen in einer Datenstruktur, **dadurch gekennzeichnet, dass** mit der Vorrichtung ein Verfahren nach einem der vorhergehenden Ansprüche durchführbar ist.

12. Vorrichtung zur Decodierung von Positionscodes von Datenelementen in einer Datenstruktur, **dadurch gekennzeichnet, dass** mit der Vorrichtung die nach einem der Verfahren der Ansprüche 1 bis 10 codierten Positionscodes decodierbar sind.

13. Datenübertragungssystem, umfassend eine Vorrichtung nach Anspruch 11 und eine Vorrichtung nach Anspruch 12.

## Claims

1. Method for coding positions of data elements in a data structure, where
position codes are associated with the data elements in a pre-determined sequence,
**characterised in that**
- the position codes are selected in such a way that other position codes can be allocated for positions of other data elements between the positions of two adjacent data elements in order to code positions of other data elements, with the code length of at least one other position code being longer than the longest code lengths of the position codes of the two adjacent data elements,
- the position codes represent rational numbers.

2. Method according to claim 1,
**characterised in that** the first and/or last position code of the data elements are selected in such a way that other position codes can be inserted before the first and/or after the last position code.

3. Method according to claim 2,
**characterised in that** the first position code is not equal to zero and/or the last position code is not equal to one.

4. Method according to one of the preceding claims,
**characterised in that** the position codes comprise binary data.

5. Method according to claim 4,
**characterised in that** the position codes comprise one or more data bit n-tuples and one or more extension bits, the quantity of the extension bits corresponding to the quantity of the data bit n-tuples.

6. Method according to one of the preceding claims,
**characterised in that** the data structure forms part of a data tree.

7. Method according to one of the preceding claims,
**characterised in that** the data elements comprise data codes for the data elements of a document.

8. Method according to claim 7,
**characterised in that** the document is an XML document.

9. Method according to claim 7 or 8,
**characterised in that** the data codes for the document are generated with an MPEG coding method.

10. Method according to claim 9,
**characterised in that** the coding method comprises a standardised MPEG-7 coding method.

11. Device for coding position codes of data elements in a data structure,
**characterised in that** a method according to one of the preceding claims can be carried out with the device.

12. Device for decoding position codes of data elements in a data structure,
**characterised in that** the position codes coded according to one of the methods in claims 1 to 10 can be decoded with the device.

13. Data transmission system comprising a device according to claim 11 and a device according to claim 12.

## Revendications

1. Procédé de codage de positions d'éléments de données dans une structure de données, dans lequel des codes de positions sont affectés aux éléments de données dans un ordre prédéfini, **caractérisé en ce que**
- les codes de positions sont choisis de manière telle que peuvent être attribués, pour des positions d'autres éléments de données entre les positions de deux éléments de données voisins, d'autres codes de positions pour le codage de positions d'autres éléments de données, la longueur de code d'au moins un autre code de position étant supérieure à la plus longue des longueurs de code des codes de positions des deux éléments de données voisins,
- les codes de positions représentent des nombres rationnels.

2. Procédé selon la revendication 1, **caractérisé en ce que** le premier et/ou le dernier code de position des éléments de données sont choisis tels que d'autres codes de positions peuvent être insérés avant le premier et/ou après le dernier code de position.

3. Procédé selon la revendication 2, **caractérisé en ce que** le premier code de position est différent de zéro et/ou le dernier code de position est différent de un.

4. Procédé selon l'une des revendications précédentes, **caractérisé en ce que** les codes de positions sont des données binaires.

5. Procédé selon la revendication 4, **caractérisé en ce que** les codes de positions comprennent un ou plusieurs n-tuples de bits de données et un ou plusieurs bits d'extension, le nombre des bits d'extension correspondant au nombre des n-tuples de bits de données.

6. Procédé selon l'une des revendications précédentes, **caractérisé en ce que** la structure de données est une partie d'un arbre de données.

7. Procédé selon l'une des revendications précédentes, **caractérisé en ce que** les éléments de données sont des codes de données pour les éléments de données d'un document.

8. Procédé selon la revendication 7, **caractérisé en ce que** le document est un document XML.

9. Procédé selon la revendication 7 ou 8, **caractérisé en ce que** les codes de données pour le document sont générés avec un procédé de codage MPEG.

10. Procédé selon la revendication 9, **caractérisé en ce que** le procédé de codage est un procédé de codage MPEG-7 standardisé.

11. Dispositif de codage de codes de positions d'éléments de données dans une structure de données, **caractérisé en ce que** le dispositif permet d'exécuter un procédé selon l'une des revendications précédentes.

12. Dispositif de décodage de codes de positions d'éléments de données dans une structure de données, **caractérisé en ce que** le dispositif permet de décoder les codes de positions codés selon l'un des procédés des revendications 1 à 10.

13. Système de transmission de données, comprenant un dispositif selon la revendication 11 et un dispositif selon la revendication 12.
